# NEUE EUROPÄISCHE PATENTSCHRIFT

(11) **EP 0 149 776 B2**
(45) Veröffentlichungstag und Bekanntmachung des Hinweises auf die Entscheidung über den Einspruch: **14.04.1993**
(45) Hinweis auf die Patenterteilung: 25.05.1988
(21) Anmeldenummer: 84114915.6
(22) Anmeldetag: 07.12.1984
(51) Int. Cl.: G01R 1/073

(54) **Adapter für ein Leiterplattenprüfgerät**
Adapter for printed circuit testing device
Adaptateur pour un dispositif de test de circuits imprimés

(30) Priorität: 08.12.1983 DE 3344457
(43) Veröffentlichungstag der Anmeldung: 31.07.1985
(73) Patentinhaber: Maelzer, Martin, D-89073 Ulm (DE); Luther, Erich, D-31515 Wunstorf (DE)
(72) Erfinder: Maelzer, Martin, D-3050 Wunstorf (DE); Luther, Erich, D-3050 Wunstorf (DE); Dehmel, Rüdiger, D-3050 Wunstorf (DE)
(74) Vertreter: Schmidt-Evers, Jürgen, Dipl.-Ing.

(56) Entgegenhaltungen:
- EP-A- 0 141 747
- EP-B- 0 026 824
- DE-A- 3 211 410
- DE-C- 2 364 786
- DE-U- 7 031 416
- DE-U- 8 335 245
- US-A- 3 906 363
- IBM Technical Disclosure Bulletin, vol. 26, No.1, 06/1983, P.218
- IBM Technical Disclosure Bulletin, vol.21, No. 11, 04/1979, p.4568-4569
- Mathematik, Kleine Enzyklopädie, Verlag Harri Deutsch, 1972, Frankfurt/M & Zürich, Seite 197

## Beschreibung

Die Erfindung betrifft einen Adapterfür ein Leiterplattenprüfgerät mittels welchem im Raster befindliche Prüfkontakte mit außer oder in und außer Raster befindlichen Prüfpunkten einer zu prüfenden Leiterplatte durch Adapterstifte verbindbar sind, mit einer ersten Führungsplatte, einer zweiten Führungsplatte und einer dritten Führungsplatte (78), die parallel zueinander und in einem festen Abstand voneinander angeordnet sind, wobei die dritte Führungsplatte sich zwischen der ersten und der zweiten Führungsplatte erstreckt und wobei die Führungsplatten Führungslöcher aufweisen, in die die Adapterstifte einsteckbar sind, wobei die Führungslöcher der ersten Führungsplatte im Raster der Prüfkontakte liegen, wobei ferner die Führungslöcher der zweiten Führungsplatte entsprechend den Prüfpunkten der Leiterplatte außer oder in und außer Raster liegen, und wobei die Führungslöcher der dritten Führungsplatte, die im Raster befindlichen Führungslöchern der zweiten Führungsplatte entsprechen, ebenfalls im Raster liegen.

Ein derartiger Adapter ist bekannt (EP-B-0 026 824). Dieser weist drei parallel und mit festem Abstand zueinander angeordente Führungsplatten auf. In der der zu prüfenden Leiterplatte abgewandten Führungsplatte sind im Raster angeordnete Führungsbohrungen vorgesehen, die leitende Führungseinsätze enthalten, welche mit im Raster befindlichen Prüfkontakten des Leiterplattenprüfgerätes verbunden sind. Die der zu prüfenden Leiterplatte zugewandte Führungsplatte sowie die mittlere Führungsplatte weisen deckungsgleiche Führungslöcher für längliche ausbiegbare Adapterstifte auf, die nach den Prüfpunkten der zu prüfenden Leiterplatte ausgerichtet sind, d. h. im Raster oder außer Raster liegen können. Die länglichen ausbiegbaren Adapterstifte greifen mit ihrem der zu prüfenden Leiterplatte abgewandten Ende jeweils in einen der mit den Prüfkontakten verbundenen Führungseinsätze ein. Die länglichen Adapterstifte weisen einen dickeren Abschnitt auf, der eine unter Federkraft stehende teleskopisch verschiebbare Prüfspitze trägt, sowie einen dünneren zur Ausbiegung bestimmten Abschnitt.

Für Adapter der hier betrachteten Art besteht die Forderung, daß die Adapterstifte sich zur Vermeidung von Kurzschlüssen nicht gegenseitig berühren dürfen. Bei den vorgegebenen Rasterabmessungen und notwendigen Abmessungen für die Adapterstifte, für die Führungslochdurchmesser und für die Dicke der Führungsplatten sowie den Abstand zwischen denselben, ist die vorgenannte Forderung nicht einfach zu erfüllen. Dabei ist zu berücksichtigen, daß die Adapterstifte möglichst leicht einführbar sein sollen.

Der Erfindung liegt die Aufgabe zugrunde, einen Adapter der eingangs bezeichneten Bauart so zu gestalten, daß die gegenseitige Berührung von Adapterstiften ausgeschlossen ist.

Die Aufgabe ist erfindungsgemäß dadurch gelöst, daß die Adapterstifte im eingesetzten Zustand eine linear verlaufende Achse aufweisen, daß die Führungslöcher der dritten Führungsplatte, die den außer Raster befindlichen Führungslöchern der zweiten Führungsplatte entsprechen, weniger weit als diese vom Raster abweichen, derart, daß sie in Führungsflucht zwischen den jeweils zwei entsprechenden Führungslöchern in der ersten und der zweiten Führungsplatte liegen, derart, daß jeweils ein in eines der Führungslöcher der ersten Führungsplatte eingesetzter Adapterstift jeweils nur in eines der Führungslöcher der dritten Führungsplatte eindringen kann und dieses Führungsloch der dritten Führungsplatte den Adapterstift ohne Berührung mit anderen Adapterstiften jeweils in ein vorgebbar zugeordnetes Führungsloch der zweiten Führungsplatte lenkt. Das Bewegungsspiel jedes Adapterstiftes im Führungsloch der ersten Führungsplatte und der Abstand zwischen der ersten Führungsplatte und der dritten Führungsplatte sowie die Größe des zugeordneten Führungsloches in der dritten Führungsplatte sind so aufeinander abgestimmt, daß des Einstreckende des Adapterstiftes zwangsläufig innerhalb des Lochrandes des Führungsloches der dritten Führungsplatte in das zugeordnete Führungsloch der zweiten Führungsplatte eintauchen muß. Von Vorteil sind an ihren Einsteckenden angespitzte Adapterstifte, wobei die Bemessung des Adapters so gewählt werden sollte, daß die Stiftspitzen bei maximalem Stift-Auslenkwinkel innerhalb der Lochränder der Führungslöcher in der dritten und zweiten Führungsplatte liegen.

Ein weiterer Vorteil besteht darin, daß der Adapter sich besonders leicht füllen läßt. Außerdem reicht es aus, wenn in die erste Führungsplatte Führungslöcher nur in einer solchen Anzahl gebohrt werden, die der Anzahl der Prüfpunkte der Leiterplatte, d.h. der Anzahl der Führungslöcher in der zweiten Führungsplatte entspricht.

Als Material für die erste Führungsplatte kann durch Glasfasern verstärkter Kunstoff auf Epoxydharz-Basis verwendet werden, der sich leicht bohren läßt. Die Verstärkungseinlage ist deshalb von Bedeutung, weil sie bei großen Führungsplatten die Tendenz zum Durchhängen verringert.

Das Maß der Versetzung, mit dem ein Führungsloch in der dritten Führungsplatte gegenüber dem ihm zugeordneten Rasterpunkt versetzt ist, wird durch das Verhältnis der Abstände zwischen der ersten Führungsplatte un der dritten Führungsplatte und des Abstandes zwischen der dritten Führungsplatte und der zweiten Führungsplatte bestimmt. Des Stift-Auslenkwinkel ergibt sich aus dem Führungsspiel des Adapterstiftes in der ersten Führungsplatte, wobei der Stiftdurchmesser, der Führungslochdurchmesser und die Führungslochlänge Einfluß haben. Untersuchungen zum Zwecke der Optimierung haben ergeben, daß es besonders günstig ist, wenn der Abstand zwischen der dritten Führungsplatte und der zweiten Führungsplatte etwa 80 % des Abstandes zwischen der ersten Führungsplatte und der zweiten Führungsplatte beträgt.

Da bei Adaptern der vorstehend beschriebenen Art die Adapterstifte unterschiedliche Schrägstellungen einnehmen, besteht die Forderung nach einer Kopfausbildung für die Adapterstifte, die eine satte Auflage im Bereich der Lochränder der oberen Führungsplatte ermöglicht. Außerdem soll eine gute Beweglichkeit gegenüber den Prüfkontakten, denen die Adapterstifte anliegen, gewährleistet sein. Diese Forderung wird von einem Adapterstift erfüllt, der an seinem dem Prüfkontakt zugewandten Ende einen kugelförmigen Kopf aufweist.

Nachfolgend wird eine Ausführungsform der Erfindung anhand von vereinfachten Zeichnungen beschrieben.

Es zeigt :
Fig. 1 einen Teilschnitt durch ein Gerät zum Prüfen von Leiterplatten, wobei der Teilschnitt senkrecht zum im Gerät aufgenommenen, erfindungsgemäß ausgestalteten Adapter verläuft;
Fig. 2 einen senkrechten Schnitt durch einen Vereinfacht dargestellten Adapter, der nur zur Erläuterung des Adapter-Grundprinzips dienen soll, nicht aber die Erfindung repräsentiert;
Fig. 3 einen senkrechten Schnitt durch den erfindungsgemäßen Adapter.

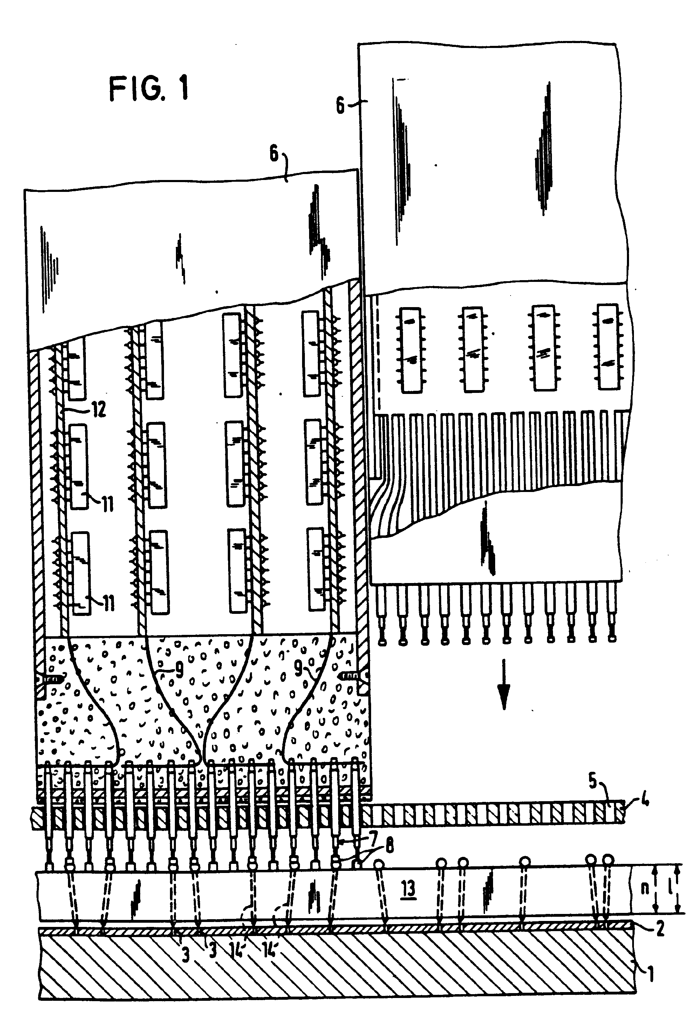

In der Fig. 1 ist eine Aufnahmeplatte des im ganzen nicht dargestellten Gerätes zum Prüfen von Leiterplatten mit 1 bezeichnet. Auf dieser Aufnahmeplatte 1 befindet sich eine Leiterplatte 2 mit Prüfpunkten 3. Oberhalb der zu prüfenden Leiterplatte 2 befinden sich eine Rasterlochplatte 4, deren Löcher 5 im Rasterangeordnet sind, und zwei in Richtung auf die Leiterplatte 2 und zurück bewegliche Moduln 6, die an ihren unteren Stirnseiten mit Prüfkontakten 7 in Form von Stiften versehen sind, welche in der herabgefahrenen Position eines Moduls 6 die Löcher 5 in der Rasterlochplatte 4 durchgreifen. Die Prüfkontakte 7 tragen teleskopisch ein- und ausfahrbare Prüfkontaktköpfe 8, die in Richtung auf ihre äußere Endstellung durch eine nicht dargestellte Feder vorgespannt sind.

Die Prüfkontakte 7 sind in den Moduln 6 durch Vergießen befestigt und stehen durch elektrische Leitungen 9 mit IC-Chips 11 tragenden leiterplatten 12 in Verbindung, die innerhalb der Moduln 6 angeordnet sind und in ihrer Gesamtheit mit den Leiterplatten 12, den IC-Chips 11 und gegebenenfalls weiteren Bauelementen eine den Prüfkontakten 7 zugeordnet Teilschalter-Matrix bilden.

Auf der Leiterplatte 2 befindet sich ein Rasteranpassungsadapter 13, der eine Vielzahl ihn durchfassender Adapterstifte 14 aufweist, die die im Raster angeordneten Prüfkontakte 7 mit den außer Raster angeordneten Prüfpunkten 3 verbinden. Die Adapterstifte 14 liegen deshalb nicht in der jeweiligen Flucht mit den Prüfkontakten, sondern erstrecken sich schräg durch den Adapter 13, wobei sie mit beiden Enden aus dem Adapter hervorragen und gegenüber derOber- und Unterseite erhabene Kontaktstellen bilden.

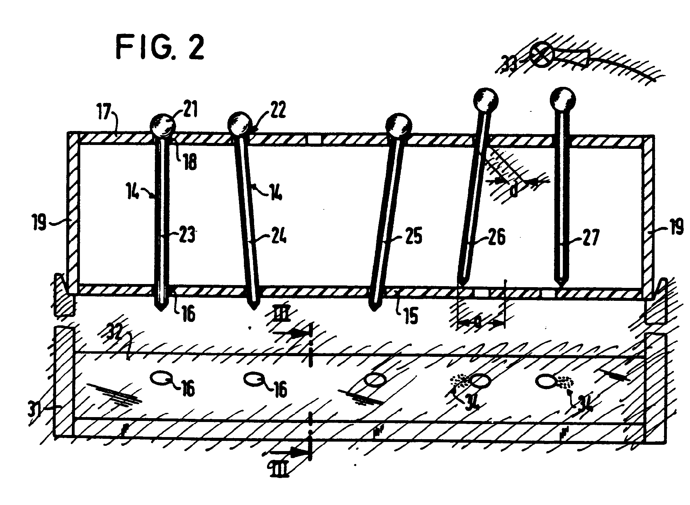

Aus der Fig. 2 ist der Aufbau des Adapters 13 zu erkennen der hier vereinfacht dargestellt und nicht die Erfindung repräsentiert. Der Adapter 13 besteht aus einer unteren Führungsplatte 15 mit im Muster der Prüfpunkte der in Fig. 2 nicht dargestellten, zu prüfenden Leiterplatte 2 angeordneten Führungslöchern 16 und einer im Abstand oberhalb, sich parallel zu dieser erstreckenden oberen Führungsplatte 17, mit im Raster angeordneten Führungslöchern 18 für die Adapterstifte 14. Die Führungsplatte 15 und die Führungsplatte 17 bilden mit stirnseitig an ihnen befestigten Stirnplatten 19 eine Kastenform.

Die Adapterstifte 14 sind von oben durch die Führungslöcher 16, 18 einführbar und sie weisen an ihren oberen Enden Kugelköpfe 21 auf, die in der vollends eingeführten Stellung auf den Rändern 22 der Führungslöcher 18 aufliegen. Es sind fünf Adapterstifte 23 bis 27 dargestellt, von denen die Adapterstifte 23 bis 26 vollends eingeführt sind, während die Adapterstifte 26 und 27 auf der Führungsplatte 15 aufstehen. Während die Führungslöcher 16, 18 für die Adapterstifte 23 und 26 miteinander fluchten, also im Raster liegen, fluchten die Führungslöcher 16,18 für die Adapterstifte 24, 25 und 27 nicht miteinander, weil diese Führungslöcher in der Führungsplatte 15 sich außer Raster befinden, wodurch eine Schrägstellung der vollends eingeführten Adapterstifte 24, 25 und 27 bedingt ist.

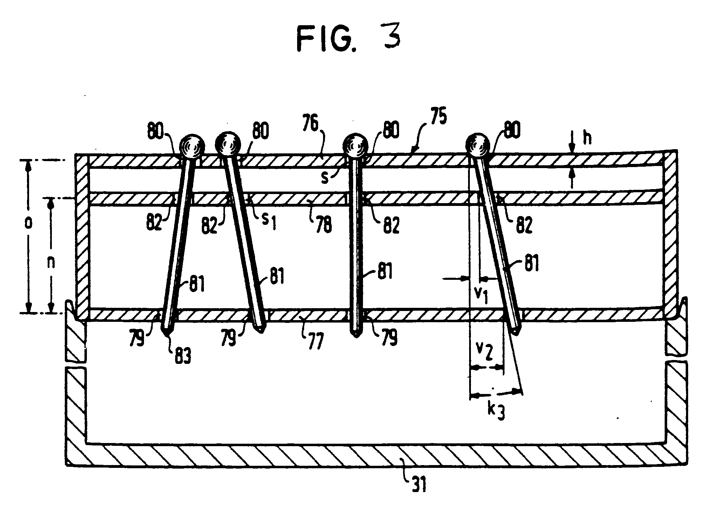

Der erfindungsgemäße Adapter 75 gemäß Figur 3 weist eine obere erste Führungsplatte 76, eine untere zweite Führungsplatte 77 und eine zwischen diesen angeordnete dritte Führungsplatte 78 auf. Die Führungsplatten 76 bis 78 sind parallel zueinander angeordnet.

Der Adapter 75 dieser Ausführungsform ist zu 100 % reproduzierbar. Das bedeutet, daß die Bestückung von außerhalb des Rasters liegenden Führungslöchern 79 in der zweiten Führungsplatte 77 nicht unbestimmt sein darf. Mit anderen Worten, jedem Führungsloch 70 in der zweiten Platte 77 ist für die Bestückung ein ganz bestimmtes Führungsloch 80 in der ersten Führungsplatte 76 zugeordnet. Die Führungslöcher 80 in der ersten Führungsplatte 76 sind im Raster angeordnet, jedoch nicht an allen Rasterpunkten, sondern nur an denjenigen, die zur Bestückung des speziellen Adapters 75 Adapterstifte 81 aufnehmen sollen. Die dritte Führungsplatte 78 ist mit Führungslöchern 80 versehen, die im und außer Raster liegen können.

Die außer Raster liegenden Führungslöcher 82 in der dritten Führungsplatte 78 sind jedoch gegenüber den nächstliegenden im Raster befindlichen Führungslöchern 80 der ersten Führungsplatte 76 weniger weit versetzt (_{V1}) als die entsprechenden Führungslöcher 79 in der zweiten Führungsplatte 77 (v₂). Der Versatz v₁ der außer Raster liegenden Führungslöcher 82 in der dritten Führungsplatte 78 ist so gewählt, daß - wenn der Versatz _{V1} ein maximaler ist - die insbesondere kegelförmige Spitze 83 der Adapterstifte 81 in jedem Fall noch in die Führungslöcher 79 der zweiten Führungsplatte 77 eintaucht unabhängig davon, unter welchem Stift-Auslenkwinkel k₃ die Adapterstifte 81 in der ersten Führungsplatte 76 eingestecktsind. DerVersatzv₁ deraußerRasterbefindlichen Führungslöcher 82 in der dritten Führungsplatte 78 ist in Kenntnis des Versatzes _{V2} der außer Raster befindlichen Führungslöcher 79 in der zweiten Führungsplatte 77 bestimmt, beispielsweise durch einen Computer ausgerechnet.

Die Dicke h der ersten Führungsplatte 76 und das Bewegungsspiel s der Adapterstifte 81 in den Führungslöchern 80 sowie das Bewegungsspiel _{S1} in den Führungslöchern 82 der dritten Führungsplatte 78 sind so aufeinander abgestimmt, daß die ggf. angespitzten Spitzen 83 der Adapterstifte 81 in die Führungslöcher 82 beim Einstecken eintauchen.

Es werden folgende Bemessungsgrößen angegeben:
Dicke jeder der drei Führungsplatten 76 bis 78 = 1,7 mm
Durchmesser aller Führungslöcher 79, 80, 82 = 1,7 mm

Durchmesser der Adapterstifte 81 = 1,35 mm die dritte Führungsplatte 78 hateinen Abstand n zurzweiten Führungsplatte 77, der etwa 80 % vom Abstand o zwischen der ersten Führungsplatte 76 und der zweiten Führungsplatte 77 beträgt. Die Adapterstifte haben einen zylindrischen Schaft, einen Kugelkopf und eine bevorzugt kegelförmige Spitze. Die Stiftlänge I ist etwa um die Größe des Kugelkopfes größer bemessen als die Querabmessung p des Adapters.

## Patentansprüche

1. Adapter für Leiterplattenprüfgerät mittels welchem im Raster befindliche Prüfkontakte mit außer oder in und außer Raster befindlichen Prüfpunkten einer zu prüfenden Leiterplatte (2) durch Adapterstifte (81) verbindbar sind, mit einer ersten Führungsplatte (76), einer zweiten Führungsplatte (77) und einer dritten Führungsplatte (78), die parallel zueinander und in einem festen Abstand voneinander angeordnet sind, wobei die dritte Führungsplatte sich zwischen der ersten und der zweiten Führungsplatte erstreckt und wobei die Führungsplatten Führungslöcher (80, 79, 82) aufweisen, in die die Adapterstifte einsteckbar sind, wobei die Führungslöcher (80) der ersten Führungsplatte (76) im Raster der Prüfkontakte liegen, wobei ferner die Führungslöcher (79) der zweiten Führungsplatte (77) entsprechend den Prüfpunkten der Leiterplatte (2) außer oder in und außer Raster liegen, und wobei die Führungslöcher (82) der dritten Führungsplatte (78), die im Raster befindlichen Führungslöchern (79) der zweiten Führungsplatte (77) entsprechen, ebenfalls im Raster liegen, dadurch gekennzeichnet, daß die Adapterstifte (81) im eingesetzten Zustand eine linear verlaufende Achse aufweisen, daß die Führungslöcher (82) der dritten Führungsplatte (78), die den außer Raster befindlichen Führungslöchern (79) der zweiten Führungsplatte (77) entsprechen, weniger weit als diese vom Raster abweichen, derart, daß sie in Führungsflucht zwischen den jeweils zwei entsprechenden Führungslöchern (79, 80) in der ersten und der zweiten Führungsplatte liegen, derart, daß jeweils ein in eines der Führungslöcher (80) der ersten Führungsplatte (76) eingesetztes Adapterstift (81) jeweils nur in eines der Führungslöcher (82) der dritten Führungsplatte (78) eindringen kann und dieses Führungsloch (82) der dritten Führungsplatte den Adapterstift (81) ohne Berührung mit anderen Adapterstiften (81) jeweils in ein vorgebbarzugeordnetes Führungsloch (79) der zweiten Führungsplatte (77) lenkt. (Fig. 3).

2. Adapter nach Anspruch 1, dadurch gekennzeichnet, daß der Abstand (n) zwischen der dritten Führungsplatte (78) und der zweiten Führungsplatte (77) etwa 80 % des Abstandes (o) zwischen der ersten Führungsplatte (76) und der zweiten Führungsplatte (77) beträgt.

3. Adapter nach Aspruch 1 oder 2, dadurch gekennzeichnet, daß die Adapterstifte (14) kugelförmige Köpfe (21) aufweisen.

## Claims

1. An adapter for a printed circuit board testing device, by means of which test contacts located on a grid can be connected by means of adapter pins (81) to test points of a printed circuit board (2) to be tested that are located off or both on and off the grid, having a first guide plate (76), a second guide plate (77) and a third guide plate (78) which are arranged parallel to and at a fixed distance from one another, the third guide plate extending between the first and second guide plates and the guide plates having guide holes (80, 79, 82) into which the adapter pins can be inserted, the guide holes (80) in the first guide plate (76) being on the grid of the test contacts, the guide holes (79) of the second guide plate (77) being off or both on and off the grid, corresponding to the test points of the printed circuit board (2), and the guide holes (82) of the third guide plate (78), which correspond to the guide holes (79) of the second guide plate (77) that are located on the grid, likewise lying on the grid, characterised in that the adapter pins (81) have a linear axis when in the inserted state, in that the guide holes (82) of the third guide plate (78), which correspond to the guide holes (79) of the second guide plate (77) which are located off the grid, deviate less far from the grid than these, so that they lie in guidance alignment between the two respective guide holes (79, 80) in the first and second guide plates such that one adapter pin (81) inserted into one of the guide holes (80) in the first guide plate (76) can only enter one of the respective guide holes (82) in the third guide plate (78) and that this guide hole (82) in the third guide plate guides the adapter pin (81) into a predeterminable associated guide hole (79) of the second guide plate (77) without it touching other adapter pins (81) (Fig. 3).

2. An adapter according to claim 1, characterised in that the distance (n) between the third guide plate (78) and the second guide plate (77) amounts to about 80% of the distance (o) between the first guide plate (76) and the second guide plate (77).

3. An adapter according to claim 1 or claim 2, characterised in that the adapter pins (14) have spherical heads (21).

## Revendications

1. Adaptateur pour un appareil de contrôle de cartes imprimées, au moyen duquel des contacts de test disposés suivant une grille peuvent être reliés par des aiguilles d'adaptation (81) à des points de test d'une carte imprimée (2) à contrôler situés en dehors de ou suivant et en dehors de la grille, comportant une première plaque de guidage (76), une deuxième plaque de guidage (77) et une troisième plaque de guidage (78) parallèles et espacées par un intervalle constant, la troisième plaque de guidage se trouvant entre la première et la deuxième, et les plaques de guidage présentant des trous de guidage (80, 79, 82) dans lesquels les aiguilles d'adaptation peuvent être enfichées, les trous de guidage (80) de la première plaque de guidage (76) étant disposés suivant la grille des contacts de test, les trous de guidage (79) de la deuxième plaque de guidage (77) étant situés suivant les points de test de la carte imprimée (2) et en dehors de ou suivant et en dehors de la grille, et les trous de guidage (82) de la troisième plaque de guidage (78) qui correspondent aux trous de guidage (79) de la deuxième plaque de guidage (77) situés suivant la grille étant également disposés suivant la grille, caractérisé en ce que chaque aiguille d'adaptation (81) disposée dans un des trous de guidage (80) de la première plaque de guidage (76) peut s'enficher seulement dans un des trous de guidage (82) de la troisième plaque de guidage (78), en ce que ce trou de guidage (82) de la troisième plaque de guidage guide l'aiguille d'adaptation (81) sans contact avec les autres aiguilles d'adaptation (81) dans un trou de guidage (79) de la seconde plaque de guidage (77) situé en avant et en ce que les trous de guidage (82) de la troisième plaque de guidage (78) correspondent aux trous de guidage (79) de la deuxième plaque de guidage (77) situés en dehors la grille s'écartent moins de la grille que ceux-ci de façon telle qu'ils soient chacun en alignement de guidage entre les deux trous de guidage (79, 80) correspondants de la première et de la deuxième plaques de guidage (figure 3).

2. Adaptateur selon la revendication 1, caractérisé en ce que la distance (n) entre la troisième plaque de guidage (78) et la deuxième (77) est d'environ 80 % de la distance (o) entre la première (76) et la deuxième (77).

3. Adaptateur selon l'une des revendications 1 ou 2, caractérisé en ce que les aiguilles d'adaptation (14) ont une tête sphérique (21).
